# EUROPÄISCHE PATENTSCHRIFT

(11) **EP 1 203 414 B1**
(45) Veröffentlichungstag und Bekanntmachung des Hinweises auf die Patenterteilung: **10.01.2007**
(21) Anmeldenummer: 00952935.5
(22) Anmeldetag: 13.07.2000
(51) Int. Cl.: H01L 33/00, H01L 31/0203, H01L 31/0232, H01S 5/022

(54) **OPTOELEKTRONISCHES BAUELEMENT UND VERFAHREN ZUR HERSTELLUNG**
OPTOELECTRONIC COMPONENT AND METHOD FOR THE PRODUCTION THEREOF
COMPOSANT OPTOELECTRONIQUE ET SON PROCEDE DE PRODUCTION

(30) Priorität: 28.07.1999 DE 19935496
(43) Veröffentlichungstag der Anmeldung: 08.05.2002
(73) Patentinhaber: Infineon Technologies AG, 81669 München (DE)
(72) Erfinder: ALTHAUS, Hans-Ludwig, D-93138 Lappersdorf (DE); GRAMANN, Wolfgang, D-93053 Regensburg (DE); KUHN, Gerhard, D-93096 Köfering (DE)
(74) Vertreter: Banzer, Hans-Jörg
(86) Internationale Anmeldenummer: PCT/DE2000/002295
(87) Internationale Veröffentlichungsnummer: WO 2001/009962

(56) Entgegenhaltungen:
- EP-A- 0 413 489
- DE-A- 19 527 026
- US-A- 4 967 241
- US-A- 5 481 386
- US-A- 5 907 151
- PATENT ABSTRACTS OF JAPAN vol. 013, no. 051 (E-712), 6 February 1989 (1989-02-06) & JP 63 244781 A (FURUKAWA ELECTRIC CO LTD:THE), 12 October 1988 (1988-10-12) cited in the application
- PATENT ABSTRACTS OF JAPAN vol. 007, no. 200 (E-196), 3 September 1983 (1983-09-03) & JP 58 097884 A (NIPPON DENSHIN DENWA KOSHA), 10 June 1983 (1983-06-10)

## Beschreibung

Die Erfindung betrifft ein optoelektronisches Bauelement mit einem lichtemittierenden Element und einem das Element abstützenden Systemträger, für die Abstützung bzw. Montage des Bauelements, wobei ein für Licht wenigstens bereichsweise durchlässiger oder wenigstens durchscheinender Hilfsträger aus einem wärmeleitenden Material vorgesehen ist, der einerseits mit dem Systemträger verbunden ist und andererseits mit dem Element thermisch gekoppelt ist und in dem eine Aussparung vorgesehen ist, durch die das Licht tritt,sowie ein Verfahren zur Herstellung eines solchen optoelektronischen Bauelements.

Lichtemittierende oder empfangende optoelektronische Bauteile werden im Hinblick auf schnelle und zuverlässige Datenübertragungswege immer wichtiger. Hierbei ist eine optische Kopplung des aktiven, meist aus Halbleitermaterialien gefertigten Elements mit der Umgebung oder einer Lichtleitfaser erforderlich. Dies stellt erhöhte Anforderungen an die die Halbleiterelemente umschließenden Gehäuse, die eine ausreichende Stabilität für den Einsatz der Bauteile unter den gewöhnlichen Bedingungen gewährleisten müssen.

Bisherige Techniken zum Aufbau von oberflächenemittierenden bzw. -empfangenden optoelektronischen Bauelementen wie beispielsweise Leuchtdioden (LEDs) als inkohärente Lichtquellen, oder insbesondere oberflächenemittierende Laserdioden, sogenannte (VCSEL = Vertical Cavity Surface Emitting Lasers), als kohärente Lichtquellen werden bisher in vergleichsweise großdimensionierten (im Bezug auf den gewünschten Miniaturisierungsgrad) Metallgehäusen (TO-Gehäuse) mit transparentem Fenster und meist in sehr aufwendiger und damit kostspieliger Fertigungstechnik hergestellt. Weiterhin sind auch kostengünstigere Bauformen mit komplett gegossenen lichtdurchlässigenKunststoffgehäusen (beispielsweise das übliche LED-Gehäuse) oder vorgespritzten Kunststoffgehäusen mit transparentem Kunststoffeinguss bekannt. Der Nachteil bei diesen Bauformen, insbesondere der milliardenfach Anwendung findenden billigen Bauform der LED-Kunststoff-Eingusstechnik, liegt insbesondere bei VCSEL-Dioden darin, dass diese bei Fertigung mit transparenten Kunststoffen nicht in ausreichender optischer Qualität und/oder mechanischer Präzision für die Ankopplung einer Lichtleitfaser gefertigt werden können. So kommen bisher nur die teuren TO-Gehäuse mit eingesetzter optischer Fensterkappe zum Einsatz.

Eine weitere Schwierigkeit im Hinblick auf die geforderte Miniaturisierung ergibt sich aus der Notwendigkeit beim Betrieb einiger optoelektronischer Bauelemente, einen die Funktion oder den Abgleich des Bauelements überwachenden Sensor oder Detektor mit in das Gehäuse des optoelektronischen Bauelements einzubauen. Dies geschieht nach dem Stand der Technik, wie ihn die EP 0 786 836 A2 zeigt, durch aufwendigen Miteinbau z.B. von Monitordioden in das verwendete TO-Gehäuse. Dieser Aufbau ist sowohl von den Verwendung findenden Gehäusematerialien als auch von den Fertigungsschritten her sehr aufwendig und damit kostenintensiv. Der kostengünstigere Aufbau durch Kunststoffeingusstechnik erlaubt aber aus Fertigungsgründen nur begrenzt die Einfügung von zusätzlichen Monitorfunktionen durch zusätzliche Elemente. Ein weiterer wesentlicher Nachteil der Kunststoffeingusstechnik liegt darin, dass bei einer Anwendung mit Faseroptik die Stabilität der verwendeten Bauformen und Materialien des Kunststoff-Gehäusekörpers für eine präzise Ankopplung der Anschlussfaser nicht ausreicht. So können die Kunststoff-Gehäusekörper maximal für sichere Ankopplungen bis zu einem Durchmesser der Glasfaser von 50 µm, nicht aber etwa insbesondere für Singlemode-Fasern eingesetzt werden.

Ein weiteres Problem bei optisch emittierenden Bauelementen stellt die bei der Erzeugung des Lichts anfallende Verlustleistung dar. Die hierbei auftretende Wärme reduziert die optische Leitungsfähigkeit durch die Aufheizung der aktiven lichtemittierenden Zonen zum Teil erheblich.

Aus der DE 195 27 026 A1 ist ein optoelektronisches Bauelement bekannt, das als lichtemitierendes oder empfangendes Element ein Strahlung aussendendes und/oder empfangendes Halbleiterbauelement aufweist. Das Halbleiterbauelement ist auf einer Trägerplatte befestigt, die auf einer Grundplatte mit einer Öffnung aufliegt. Die vom Halbleiterbauelement ausgehende Strahlung kann durch die Trägerplatte und die Öffnung in der Grundplatte hindurch austreten. Zur Fokusierung der vom Halbleiterbauelement ausgehenden Strahlung ist die Trägerplatte im Bereich der Öffnung der Grundplatte linsenförmig ausgebildet.

Aus den Patents Abstracts of Japan, E-1290, 1992, Vol. 16/No. 542, JP 4-207079 A ist ein Schichtaufbau auf einem Substrat bekannt, in dem eine Fotodiode zur Detektion des zum Schichtaufbau ausgesandten Lichts ausgebildet ist.

Aus der US 4,967,241 ist ferner ein Schichtaufbau auf einem Substrat bekannt, in dem eine trichterförmige Durchführung für das vom Schichtaufbau ausgesandte Licht ausgebildet ist. Zur Detektion des vom Schichtaufbau ausgesandten Lichts ist im Substrat eine Fotodiode ausgebildet.

Ein auf einem Hilfsträger mit einer Aussparung vormontiertes optoelektronisches Element beschreibt die EP-A-0 413 489.

Schließlich offenbart Patents Abstract of Japan, E-712, 1989, Vol. 13/No. 51, JP 63-244781 A ein rohrförmiges Gehäuse mit einer trichterförmigen Öffnung, hinter der ein lichtemitierendes Element befestigt ist. Das von dem lichtemitierenden Element ausgehende Licht wird durch eine in der trichterförmigen Öffnung angeordnete Kugellinse fokussiert.

Aufgabe der Erfindung ist es, ein optoelektronisches Bauelement zur Verfügung zu stellen, welches kostengünstig und mit den erforderlichen optischen Qualitäten herzustellen ist und die durch Verlustleistung im Element erzeugte Wärme vermindert und eine gute optische Abbildung bzw. Auskopplung des Lichts gewährleistet.

Die Lösung dieser Aufgabe erfolgt vorrichtungsmäßig nach den Merkmalen des Anspruchs 1 und verfahrensmäßig nach den Merkmalen des Anspruchs 18.

Erfindungsgemäß ist vorgesehen, dass ein für das Licht wenigstens bereichsweise durchlässiger oder wenigstens durchscheinender Hilfsträger aus einem wärmeleitenden Material vorgesehen ist, der einerseits mit dem Systemträger verbunden ist und andererseits mit dem Element thermisch gekoppelt ist. Das Merkmal "bereichsweise durchlässig oder wenigstens durchscheinend" bedeutet, dass entweder das Material des Hilfsträgers selbst lichtdurchlässig ist, oder eine lichtdurchlassende Öffnung oder wenigstens Aussparung vorgesehen ist.

Die Erfindung schlägt ferner vor, einen Hilfsträger für das lichtemittierende oder empfangende Element vorzusehen, der für eine optimale Wärmeableitung insbesondere zum Systemträger hin - bei kleinsten Abmessungen - sorgt, und gleichzeitig den Lichtaus- bzw. -eintritt nicht behindert bzw. eine gezielte Lichtemission gewährleistet. Ein weiterer sich hieraus ergebender Vorteil ist, dass die Montage des mit dem Hilfsträger verbundenen Elements auf dem Systemträger wesentlich vereinfacht wird, da die Abmessungen des Systemträgers größer als die des Elements alleine sind und der Hilfsträger weniger empfindlich in der Handhabung ist.

Dem Prinzip der Erfindung folgend ist in dem Hilfsträger eine Aussparung vorgesehen, durch die das Licht tritt. Hierdurch können auch Lichtstrahlen den Hilfsträger durchdringen, für die das Material desselben zu wenig transparent oder gar nicht durchscheinend ist. Dabei ist vorgesehen, dass die Aussparung im Hilfsträger mit einer aus diesem gebildeten dünnen Abdeckschicht abgedeckt ist, durch die das Licht tritt. Hierdurch wird die Dicke des zu durchstrahlenden Licht absorbierenden Materials auf ein Minimum reduziert. Eine Ausbildung eines zu durchstrahlenden Sensors ist in der relativ dünnen Abdeckschicht möglich.

Nach einer bevorzugten Ausgestaltung der Erfindung ist der Hilfsträger flächig mit dem Element mechanisch verbunden. Hierdurch ist eine gute Wärmeabfuhr von dem Element in den Hilfsträger und eine sichere Verbindung gewährleistet. Hierbei ist vorteilhafterweise der Hilfsträger vermittels einer elektrischen Kontaktierung mit dem Element elektrisch verbünden, was eine Stromversorgung und Signalableitung erleichtert.

Gemäß der Erfindung ist auf bzw. in dem Hilfsträger ein gegenüber Licht empfindlicher Sensor ausgebildet. Ebenso ist nach einer anderen Ausgestaltung der Erfindung vorgesehen, einen gegenüber Licht empfindlichen Sensor auf bzw. in dem Element auszubilden. Der Vorteil hierbei ist, dass ein Sensor nicht mehr durch aufwendige Montageschritte in das mit dem Element gemeinsame Gehäuse eingebracht werden muss. Die direkte Integration in den Hilfsträger ermöglicht es bei Durchstrahlen desselben beispielsweise die Qualität oder Lichtmenge des emittierten Lichtes unabhängig vom Element zu erfassen. Durch eine solche Ausgestaltung eines Sensors im Hilfsträger oder dem Element selbst können aufwendige und teure Herstellungsschritte eingespart werden, und im übrigen auch die Ausbeute der Produktion erhöht werden.

Nach einem weiteren Aspekt der Erfindung ist vorgesehen, den Systemträger mit einer Öffnung zu versehen, die einen Durchtritt des Lichtes durch diesen ermöglicht. Diesen Ausgestaltungen folgend ist die Aussparung in dem Hilfsträger und/oder die Öffnung die Öffnung des Systemträgers vorteilhafterweise kegelstumpfförmig, pramidenstumpfförmig oder zylinderförmig mit glatten Seitenflächen ausgebildet. Hierdurch kann ein divergenter Strahl ungehindert austreten bzw. ein eintretender Strahl durch geeignete Maßnahmen in die Lichtdurchtrittsfläche konzentriert werden.

Nach der Erfindung ist vorteilhafterweise vorgesehen, in der optischen Achse des Bauelements eine fokussierende und/oder den Strahlengang des Lichts verändernde optische Einrichtung anzuordnen. Die Strahlqualität und -form und die Aus- bzw. Einkopplung des Lichts kann hierdurch in vorteilhafter Weise beeinflußt werden. Dem folgend ist vorteilhafterweise gemäß einer Ausgestaltung der Erfindung die optische Einrichtung innerhalb der Öffnung des Systemträgers und/oder der Aussparung des Hilfsträgers eingepasst.

Die optische Einrichtung ist gemäß einem weiteren vorteilhaften Aspekt der Erfindung eine Linse oder ein lichtdurchlässiges Plättchen ausgebildet, welches unter einem definierten Winkel - der nach einer anderen vorteilhaften Ausgestaltung der Erfindung so gewählt ist, dass ein möglichst geringer Anteil von der Oberfläche des Plättchens reflektiert wird, und/oder dass ein vorbestimmter Anteil in eine definierte Richtung gespiegelt wird - zwischen seiner Flächennormale und der optischen Achse des Bauelements angeordnet ist. Durch die Reflektion eines Anteils des ausgesandten Lichtes kann dieser in den Sensor zu dessen Auswertung eingekoppelt werden.

Ein Haft- oder Klebemittel ist bevorzugterweise vorgesehen, vermittels welchem die optische Einrichtung innerhalb der Öffnung des Systemträgers befestigt ist. Hierdurch wird eine sichere Fixierung der optischen Einrichtung erreicht.

Bevorzugterweise sind für die selbstjustierende Ausrichtung der optischen Einrichtung bezüglich der optischen Achse des Bauelements an den Seitenflächen und/oder Kanten der Aussparung des Hilfsträgers und/oder den Seitenflächen und/oder Kanten der Öffnung des Systemträgers vorbestimmte Stützpunkte bzw. Stützkanten vorgesehen. Hierdurch entfällt eine aufwendige und fehlerbehaftete Positionierung der optischen Einrichtung bezüglich des Elements. Eine schnelle und kostengünstige Einpassung der optischen Einrichtung ist somit möglich. Dem folgend sind die Stützpunkte bzw. Stützkanten vorteilhafterweise an den dem Element abgewandten äußersten Rändern der Aussparung und/oder an den dem Element abgewandten äußersten Rändern der Öffnung und/oder an einem mittleren Abschnitt der Öffnungs- oder Aussparungs-Wandung angeordnet.

Der Sensor ist nach einem weiteren bevorzugten Aspekt der Erfindung durch ein in bzw. auf dem Hilfsträger bzw. dessen Abdeckschicht oder dem Element strukturiertes aktives elektronisches Bauteil, insbesondere Halbleiter-Bauteil, ausgebildet, wobei bevorzugterweise der Hilfsträger aus einem Siliziumsubstrat oder einer Silizium-Kohlenstoff-Verbindung besteht und nach einer weiteren Fortbildung der Sensor mit dem Element mittelbar über eine andere Schaltung oder unmittelbar elektrisch gekoppelt ist. Hierdurch wird eine besonders zuverlässige und kostengünstige Integration des Sensors, der von Vorteil durch eine Diode oder einen Transistor ausgebildet ist, im Hilfsträger bzw. dem Element ermöglicht.

Das Element ist nach einer besonders bevorzugten Ausgestaltung der Erfindung durch einen VCSEL-Chip (kohärent abstrahlende Dioden), einen IRED-Chip (IRED = InfraRed Emitting Diode), spontan emittierende Dioden oder einen sonstigen an einer Oberfläche lichtemittierenden Chip gebildet. Die anfallende, durch Verlustleistung erzeugte Wärme wird durch den gut wärmeleitenden Hilfsträger schnell an den mit dem Hilfsträger verbundenen Systemträger abgegeben und somit ein zuverlässiger Betrieb, ohne Einschränkungen durch Aufheizung, ermöglicht. Die lichtemittierende Seitenfläche ist hierbei dem Hilfsträger zugewandt, und dieser wird von dem Licht durchstrahlt.

Nach einer weiteren Ausgestaltung der Erfindung ist der Systemträger mit dem daran befestigten Hilfsträger mit einer lichtundurchlässigen Press-, Verguss- oder Moldmasse wenigstens bereichsweise vergossen bzw. vermoldet. Hierdurch wird eine sichere Handhabung und ein zuverlässiges Betreiben des optoelektronischen Bauelements gewährleistet und eine Miniaturisierung auf beispielsweise SMD-Dimensionen des Gehäuses ermöglicht.

Das erfindungsgemäße Verfahren zur Herstellung eines optoelektronischen Bauelements, bestehend aus einem an einer Lichtdurchtrittsfläche lichtemittierenden Element und einem das Element abstützenden Systemträger, sieht vor, einen für das Licht wenigstens bereichsweise durchlässigen oder wenigstens durchscheinenden Hilfsträger aus einem wärmeleitenden Material mit dem Element zu verbinden, wobei eine thermische Kopplung zwischen dem Hilfsträger und dem Element gefertigt wird. Hiernach ist ein mechanisches Verbinden des das Element tragenden Hilfsträgers mit dem Systemträger vorgesehen.

Eine Aussparung für den ungehinderten Lichtdurchtritt durch den Hilfsträger wird gemäß eines erfindungsgemäßen Verfahrensschrittes durch anisotropes Ätzen vor dem Verbinden desselben mit dem Element eingebracht. Dem folgend wird in einem weiteren Verfahrensschritt beim Ätzen der Aussparung eine die Aussparung abdeckende Abdeckschicht mit einer Dicke von <= 50 µm stehen gelassen. Hierdurch wird die Ausbildung eines zu durchstrahlenden Sensors auch bei absorbierendem Material des Hilfsträgers ermöglicht.

Nach einem weiteren Verfahrensschritt ist die Ausbildung eines gegenüber dem Element eigenständigen Sensors auf bzw. in dem Hilfsträger und/oder dem Element, vor dem Verbinden derselben, vermittels halbleitertechnologischer Strukturierungsschritte vorgesehen.

Nach einem weiteren vorteilhaften Verfahrensschritt wird eine Vielzahl von Hilfsträgern, die in einem weiteren Verfahrensschritt zu vereinzeln sind, gemeinsam in einem Verbund mit eigenständigen Sensoren und/oder den damit zu verbindenden Elementen verbunden.

Weiterhin bevorzugt ist die Befestigung einer optischen Einrichtung in der Öffnung des Systemträgers, wobei vorteilhafterweise die optische Einrichtung in die Öffnung vermittels eines Haft- oder Klebemittels eingeklebt wird.

Der Systemträger wird mit dem daran befestigten Hilfsträger und dem daran befindlichen Element von Vorteil mit einer lichtundurchlässigen Press-, Verguss- oder Moldmasse wenigstens bereichsweise vergossen bzw. vermoldet.

Weitere Vorteile, Besonderheiten und zweckmäßige Weiterbildungen der Erfindung ergeben sich aus den Unteransprüchen.

Nachfolgend wird die Erfindung anhand der Zeichnung weiter erläutert. Im Einzelnen zeigen die schematischen Darstellungen in:
- Figur 1: eine schematische Schnitt-Darstellung eines optoelektronischen Bauelements mit einer Linse zur Erklärung der Erfindung; und in
- Figur 2: eine schematische Schnitt-Darstellung eines weiteren optoelektronischen Bauelements mit einem Schräg angeordnetem Aus- bzw. Eintrittsfenster zur Erklärung der Erfindung;
- Figur 3: eine schematische Schnitt-Darstellung eines weiteren bevorzugten Ausführungsbeispieles eines erfindungsgemäßen optoelektronischen Bauelements mit einer kohärent abstrahlenden Laserdiode und einer Linse; und
- Figur 4: eine schematische Darstellung der Anordnung der Laserdiode und des Hilfsträgers aus Figur 3 in Aufsicht.

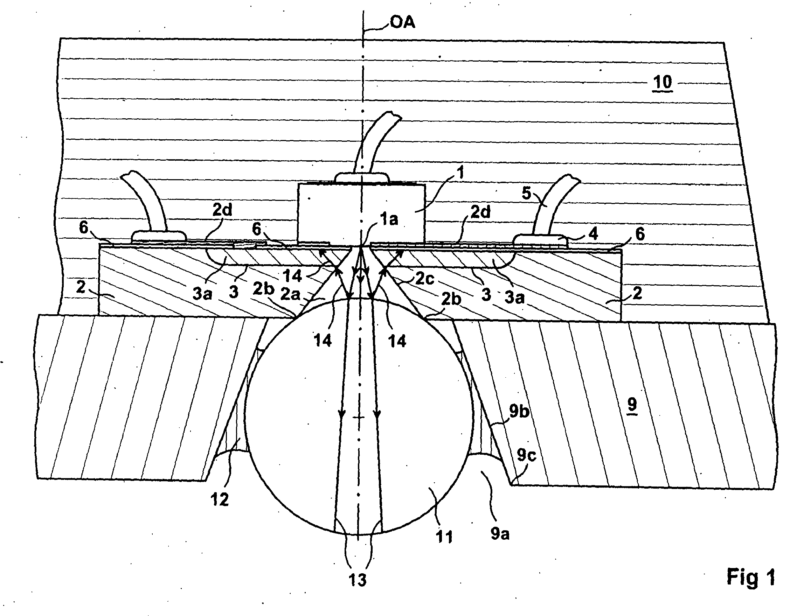

In Figur 1 ist ein Schnitt durch ein optoelektronisches Bauelement dargestellt. Ein emittierendes Element 1, das thermisch und mechanisch mit einem Hilfsträger 2 gekoppelt bzw. verbunden ist, wird durch einen Systemträger 9 abgestützt, wobei der Hilfsträger 2 mit dem Systemträger 9 verbunden ist.

Das Element 1 ist durch einen an der Lichtdurchtrittsfläche 1a Licht 13 emittierenden Chip z.B. eine spontan emittierende Diode oder einen VCSEL-Chip ausgebildet. Die Stromversorgung erfolgt durch Bonddrähte 5, die mit Lot (Bondpad) 4 mit leitenden Schichten (Metallisierungen) 2d verbunden sind, die wiederum den Strom zum Element 1 führen. Die leitenden Schichten 2d sind hierbei durch isolierende Schichten 6 teilweise von dem Element 1 und dem Hilfsträger 2 isoliert. Das Element 1 emittiert an der Lichtdurchtrittsfläche 1a in Richtung des Hilfsträgers 2, um möglichst an der aktiven Zone des Elements 1 die dort entstehende Wärme durch die Wärmekopplung mit dem Hilfsträger 2 abzuführen.

Der Hilfsträger 2 kann hierzu bei Lichtwellenlängen des aus- bzw. eingekoppelten Lichts 13 von mehr als 1200 nm aus Silizium gefertigt sein, da dieses für solche Lichtwellen transparent ist und hervorragende Wärmeleiteigenschaften besitzt. In diesem Fall wird von der Lichtdurchtrittsfläche 1a durch das Material des Hilfsträgers 2 das Licht 13 emittiert. Bei einer in Figur 1 dargestellten Anwendung für Lichtwellen mit einer Wellenlänge kleiner 1200 nm ist Silizium nicht mehr transparent genug, und daher nicht mehr geeignet. Bei einer Anwendung, bei der keine Verlustleistung mit der damit zusammenhängenden Abwärme entsteht, ist an sich Glas als Material für den Hilfsträger 2 denkbar. Sobald aber Wärme abgeführt werden muss, ist das schlecht wärmeleitende Glas nicht mehr verwendbar. So werden für Anwendungen, bei denen Verlustleitungen auftreten, wie beispielsweise Laserdioden (VCSEL-Dioden), gut wärmeleitende Materialien für den Hilfsträger 2 zum Einsatz kommen, um einen Wärmestau mit der damit.einhergehenden Einschränkung der Funktionalität bzw. der optischen Leistungsfähigkeit des Bauelements zu verhindern.

Um dennoch die guten Wärmeleiteigenschaften des Silizums bei ungehindertem Durchtreten des emittierten Lichtes 13 zu nutzen, ist in dem aus Silizum gefertigten Hilfsträger 2 eine Aussparung 2a vorgesehen, die so angeordnet ist, dass der lichtemittierende Bereich der Lichtdurchtrittsfläche 1a über der kleinen Aussparung 2a im Hilfsträger 2 angeordnet ist. Die Aussparung 2a kann hierbei durch Ätzen hergestellt werden. Um hierbei gute Ergebnisse hinsichtlich der Geometrie der Aussparung 2a (eine Kegelstumpfform oder eine Pyramidenstumpfform ist am besten geeignet) und der Beschaffenheit der Seitenflächen 2c der Aussparung 2a zu erzielen, wird die anisotrope mikromechanische Ätztechnik verwendet. Vermittels dieser Technik ist die Realisierung einer möglichst kleinen (um noch genügend Material zum Wärmeabtransport stehen zu lassen) kegel- oder pyramidenstumpfförmigen Aussparung 2a im Bereich einiger 10 µm mit vollstöndig glatter bzw. ebener Montagefläche (an der das Element 1 bzw. der Systemträger 9 befestigt wird) möglich.

Die erfindungsgemäße Abdeckung der Aussparung 2a, die durch den Hilfsträger 2 selbst gebildet wird, ist in Figur 1 nicht dargestellt.

Damit das emittierte Licht 13 weiter ungehindert vom Bauelement abgestrahlt werden kann, ist in dem mit dem Hilfsträger 2 verbundenen Systemträger 9 eine Öffnung 9a vorgesehen, die ebenfalls kegel- oder pyramidenstumpfförmig aber auch zylindrisch sein kann und mit ebenen Seitenflächen 9b ausgebildet ist. Hierbei ist die Öffnung 9a des Systemträgers 9 so ausgestaltet, dass sie eine optisches Einrichtung zur Veränderung der Strahlform oder des Strahlweges beispielsweise in Form einer fokussierenden Linse 11 aufnehmen kann. Somit kann schon eine optimale Auskopplung des Lichts 13 ermöglicht werden. Um die Linse 11 sicher zu fixieren und das emittierende Element 1 von der Umwelt abzuschließen ist ein Klebemittel 12 vorgesehen, das die Linse 11 in der Öffnung hält. Da eine präzise Anordnung der optischen Einrichtung bezüglich der optischen Achse OA des optoelektronischen Bauelements wichtig für die Funktion desselben ist, sind Stützpunkte bzw. Stützkanten an den dem Element 1 abgewandten äußersten Rändern 2b der Aussparung 2a für die selbstjustierende Ausrichtung der Linse 11 vorgesehen, an denen sich die Linse 11 beim Einbau derselben selbst ausrichtet.

Somit kann die Linse 11 präzise den emittierten Lichtstrahl 13 beispielsweise in eine nicht dargestellte Lichtleitfaser abbilden und einkoppeln. An Stelle der äußersten Ränder 2b der Aussparung 2a sind auch die dem Element 1 abgewandten äußersten Ränder 9c der Öffnung 9a als Stützkanten bzw. ein definierter Punkt im mittleren Abschnitt der Öffnungs- oder Aussparungs-Wandung 9b oder 2c geeignet.

Um die Funktion des emittierenden Elements 1 überwachen zu können ist in dem Hilfsträger 2 ein Sensor 3 ausgebildet. Dieser ist gegenüber dem emittierten Licht empfindlich ausgestaltet und als eine Diode oder ein Transistor mit einem dotierten Bereich 3a ausgebildet. Der Sensor 3 wird ebenfalls durch leitende Schichten 2d bzw. Bonddrähte 5 angeschlossen bzw. werden über solche sein Signal abgenommen. Es ist auch möglich, eine elektronische Schaltung zur Auswertung oder Bearbeitung des Signals des Sensors 3 im Hilfsträger auszubilden.

Um eine zur Auswertung genügende Menge Auswertelicht 14 des emittierten Lichts 13 in den als Photodiode wirkenden an der Seitenfläche 2c der Aussparung 2a zugänglichen pn-Übergang des Sensors 3 zu reflektieren, ist die Linse entsprechend vergütet. Es ist auch möglich den Sensor in der die Aussparung 2a abdeckenden, dünnen (≤ 50 µm) Abdeckschicht vorzusehen (diese läßt man beim Ätzen der Aussparung stehen). Die Abdeckschicht wird direkt vom Licht durchstrahlt. Da die Schicht hinreichend dünn ist wird nur eine geringe Menge (≤ 10 %) an Licht absorbiert und zur Auswertung (Monitorfunktion) genutzt.

Der eine Einheit bildende Aufbau von Element 1, Hilfsträger 2 und Systemträger 9 ist zum Schutz mit einer lichtundurchlässigen Moldmasse 10 umhüllt, die so geformt ist, dass ein Lichtaustritt durch den Systemträger möglich bleibt. Dadurch wird das Element 1 und der Sensor 3 vor ungewünschtem Fremdlicht oder Reflexen geschützt und leicht zu handhaben.

Der erfindungsgemäße Aufbau ermöglicht ein elektrooptisch aktives, oberflächenemittierendes Bauelement in Leadframe-Moldtechnik, das neben der reinen Emission eine Monitorfunktion enthält. Insbesondere sind somit optoelektronische SMD-Bauelemente beispielsweise zur Realisierung faseroptischer Komponenten möglich.

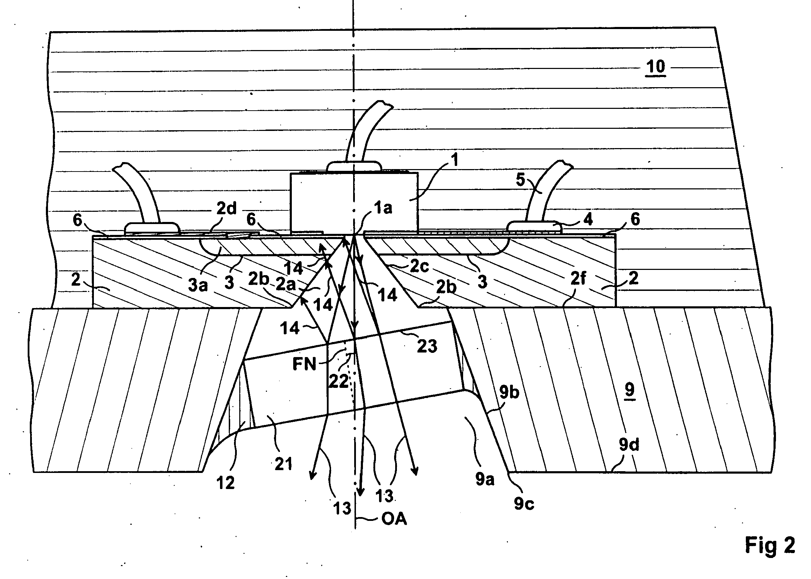

Figur 2 zeigt einen Schnitt durch eine Variante des optoelektronischen Bauelements, bei dem an Stelle einer Linse ein für das emittierte Licht 13 lichtdurchlässiges Plättchen 21 in der Öffnung 9a des Systemträgers 9 mit einem Klebemittel 12 befestigt ist (in den Figuren bezeichnen gleiche Bezugsziffern gleiche oder analoge Bestandteile der erfindungsgemäßen Vorrichtung). Die Befestigung des Plättchens kann hierbei wie dargestellt in der Öffnung 9a oder auch an der Außenseite 9d des Systemträgers 9 oder an der dem Element 1 abgewandten Seitenfläche 2f des Hilfsträgers 2 erfolgen.

Das Plättchen 21 kann (wie im Beispiel dargestellt) unter einem definierten Winkel 22 zwischen seiner Flächennormale FN und der optischen Achse OA des Bauelements angeordnet sein. Hierdurch können optimale Transmissionseigenschafen des Plättchens 21 bzw. Richtungen und Anteile 14 des rückgespiegelten emittierten Lichtes 13 zur Auswertung durch den Sensor 3 eingestellt werden. Der definierte Winkel 22 kann hierbei so gewählt sein, dass ein möglichst hoher Anteil von der Oberfläche 23 des Plättchens 21, die entsprechend verspiegelt oder vergütet sein kann, auf den Sensorbereich (Monitor) reflektiert wird oder ein möglichst hoher Anteil durch das Plättchen tritt. Es ist wiederum möglich den Sensor in der die Aussparung 2a abdeckenden, dünnen (≤ 50 µm) Abdeckschicht vorzusehen. Die Abdeckschicht wird auch hier direkt vom Licht durchstrahlt. Da die Schicht hinreichend dünn gewählt ist, wird auch im Fall von absorbierendem Material nur eine geringe Menge (<= 10 %) an Licht absorbiert und zur Auswertung (Monitorfunktion) genutzt.

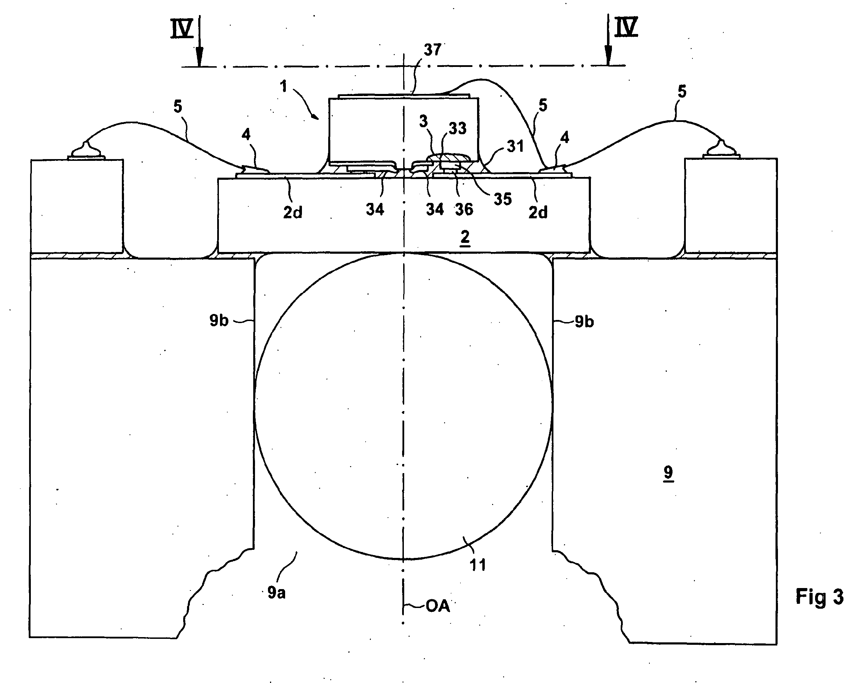

Ein Schnitt durch eine weitere Variante eines optoelektronischen Bauelements mit einem VCSEL-Chip als lichtemittierendem Element 1 ist in Figur 3 dargestellt. Hier wird beim Hilfsträger 2 anstelle von Silizium SiC, das optisch transparent und gut wärmeleitend ist, als Material verwendet. Hierbei ist allerdings eine Ausbildung eines Sensors im Hilfsträger vermittels halbleitertechnologischer Strukturierungsschritte nur mit hohem Aufwand möglich.

Der Sensor 3 für die gewünschte Monitorfunktion ist im Beispiel im Element 1 selbst durch einen geeignet dotierten Bereich 33 ausgebildet. Die Stromversorgung und Signalableitung erfolgt wieder durch an Bondpads 4 kontaktierte Bonddrähte 5, wobei die weitere Zuleitung zum VCSEL-Chip und zum Sensor 3 wieder über leitende Schichten 2d und eine Kontaktierungsfläche 37 erfolgt, wobei die leitenden Schichten mit der Stromzuführung 34 und den Kontaktierungsflächen 35 über ein Kontaktmittel 36 (beispielsweise Lot) elektrisch verbunden sind.

In der hier im Beispiel gebohrt ausgeführten Öffnung 9a des Systemträgers 9 ist eine Linse 11 passgenau in dieser durch die Seitenflächen 9b gehalten. Zur Verbesserung der Aus- bzw. Einkopplung des Laserlichtes in den Hilfsträger 2 kann ein ungewünschte Effekte (Spiegelung oder andere strahlbeeinflussende Effekte) verminderndes Material 31 verwendet werden.

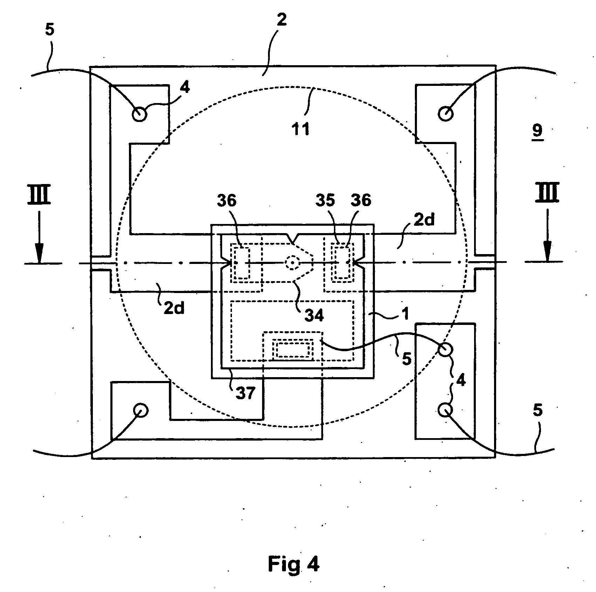

Figur 4 zeigt eine Aufsicht des als VCSEL-Chip ausgebildeten Elements 1 und des Hilfsträgers 2 aus Figur 3 in der dort mit VI bezeichneten Richtung. Die Bezeichnungen entsprechen denen aus Figur 3.

Allgemein werden hier optoelektronische Bauelemente mit einem lichtemittierenden oder empfangenden Element 1 und einem das Elemente 1 abstützenden Systemträger 9 für die Abstützung beziehungsweise Montage des Bauelements beschrieben, wobei ein für das Licht wenigstens bereichsweise durchlässiger oder wenigstens durchscheinender Hilfsträger 2 aus einem wärmeleitenden Material vorgesehen ist, der einerseits mit dem Systemträger 9 verbunden ist und andererseits mit dem Element 1 thermisch gekoppelt ist.

## Patentansprüche

1. Optoelektronisches Bauelement mit einem lichtemittierenden Element (1) und einem das Element (1) abstützenden Systemträger (9), für die Abstützung bzw. Montage des Bauelements, wobei ein für Licht wenigstens bereichsweise durchlässiger oder wenigstens durchscheinender Hilfsträger (2) aus einem wärmeleitenden Material vorgesehen ist, der einerseits mit dem Systemträger (9) verbunden ist und andererseits mit dem Element (1) thermisch gekoppelt ist und in dem eine Aussparung (2a) vorgesehen ist, durch die das Licht tritt, wobei die Aussparung (2a) im Hilfsträger (2) mit einer aus diesem gebildeten dünnen Abdeckschicht abgedeckt ist, durch die das Licht tritt,
**dadurch gekennzeichnet,**
**dass** ein gegenüber Licht empfindlicher Sensor vorgesehen ist, der auf bzw. in dem Element (1) oder auf bzw. in dem Substrat des Hilfsträgers (2) ausgebildet ist,
**dass** in der optischen Achse (OA) des Bauelements eine fokussierende und/oder den Strahlengang des Lichts verändernde optische Einrichtung (11 oder 21) vorgesehen ist, und
**dass** der Sensor in einem Bereich angeordnet ist, in den die fokussierende und/oder den Strahlengang des Lichts verändernde optische Einrichtung (11 oder 21) einen Teil eines vom E-lemeht (1) emittierten Lichtstrahls reflektiert.

2. Optoelektronisches Bauelement nach Anspruch 1,
**dadurch gekennzeichnet,**
**dass** der Hilfsträger (2) eine elektrische Kontaktierung aufweist, vermittels welcher dieser mit dem Element (1) elektrisch verbunden ist.

3. Optoelektronisches Bauelement nach Anspruch 1 oder 2,
**dadurch gekennzeichnet,**
**dass** der Hilfsträger (2) zwischen dem Systemträger (9) und dem Element (1) angeordnet ist und der Hilfsträger (2) und das Element (1) im wesentlichen flächig miteinander mechanisch verbunden sind.

4. Optoelektronisches Bauelement nach einem der Ansprüche 1 bis 3,
**dadurch gekennzeichnet,**
**dass** der aus lichtundurchlässigem Material bestehende Systemträger (9) mit einer Öffnung (9a) versehen ist, durch die Licht tritt.

5. Optoelektronisches Bauelement nach einem der Ansprüche 1 bis 4,
**dadurch gekennzeichnet,**
**dass** die Aussparung (2a) in dem Hilfsträger (2) und/oder die Öffnung (9a) des Systemträgers (9) kegelstumpfförmig, pyramidenstumpfförmig oder zylinderförmig mit glatten Seitenflächen (2c) ihrer Wandung ausgebildet ist.

6. Optoelektronisches Bauelement nach einem der Ansprüche 1 bis 5,
**dadurch gekennzeichnet,**
**dass** die optische Einrichtung (11 oder 21) innerhalb der Öffnung (9a) des Systemträgers (9) und/oder der Aussparung (2a) des Hilfsträgers (2) eingepasst ist.

7. Optoelektronisches Bauelement nach einem der Ansprüche 1 bis 6,
**dadurch gekennzeichnet,**
**dass** die optische Einrichtung als eine Linse (11) oder ein lichtdurchlässiges Plättchen (21) ausgebildet ist, wobei das Plättchen (21) unter einem definierten Winkel (22) zwischen seiner Flächennormale (FN) und der optischen Achse (OA) des Bauelements angeordnet ist.

8. Optoelektronisches Bauelement nach Anspruch 7
**dadurch gekennzeichnet,**
**dass** der Winkel (22) der Plättchenanordnung so gewählt ist, dass ein möglichst geringer Anteil von der Oberfläche (23) des Plättchens (21) reflektiert wird, und/oder dass ein vorbestimmter Anteil (14) in eine definierte Richtung gespiegelt wird.

9. Optoelektronisches Bauelement nach einem der Ansprüche 1 bis 8,
**dadurch gekennzeichnet,**
**dass** ein Haft- oder Klebemittel (12) vorgesehen ist, vermittels welchem die optische Einrichtung (11 oder 21) innerhalb der Öffnung (9a) des Systemträgers (9) und/oder der Aussparung (2a) des Hilfsträgers (2) befestigt ist.

10. Optoelektronisches Bauelement nach einem der Ansprüche 1 bis 9,
**dadurch gekennzeichnet,**
**dass** bezüglich der optischen Achse (OA) des Bauelements an den Seitenflächen (2c) und/oder Kanten der Aussparung (2a) des Hilfsträgers (2) und/oder den Seitenflächen (9b) und/oder Kanten der Öffnung (9a) des Systemträgers (9) vorbestimmte Stützpunkte bzw. Stützkanten (2b) für die selbstjustierende Ausrichtung der optischen Einrichtung (11 oder 21) vorgesehen sind.

11. Optoelektronisches Bauelement nach Anspruch 10,
**dadurch gekennzeichnet,**
**dass** die Stützpunkte bzw. Stützkanten an den dem Element (1) abgewandten äußersten Rändern (2b) der Aussparung (2a) und/oder an den dem Element (1) abgewandten äußersten Rändern (9c) der Öffnung (9a) und/oder an einem mittleren Abschnitt der Öffnungs- oder Aussparungs-Wandung (-Seitenflächen) (9b oder 2c) angeordnet sind.

12. Optoelektronisches Bauelement nach einem der Ansprüche 1 bis 11,
**dadurch gekennzeichnet,**
**dass** der Sensor (3) durch ein in bzw. auf dem Hilfsträger (2) bzw. der aus diesem gebildeten Abdeckschicht oder dem Element (1) strukturiertes aktives elektronisches Bauteil, insbesondere Halbleiter-Bauteil, ausgebildet ist.

13. Optoelektronisches Bauelement nach einem der Ansprüche 1 bis 12,
**dadurch gekennzeichnet,**
**dass** der Sensor (3) mit dem Element (1) mittelbar über eine andere Schaltung oder unmittelbar elektrisch gekoppelt ist.

14. Optoelektronisches Bauelement nach Anspruch 2 oder 3,
**dadurch gekennzeichnet,**
**dass** das Halbleiter-Bauteil durch eine Diode oder einen Transistor ausgebildet ist.

15. Optoelektronisches Bauelement nach einem der Ansprüche 1 bis 14,
**dadurch gekennzeichnet,**
**dass** der Hilfsträger (2) ein Substrat aus Silizium oder aus einer SiC-Verbindung aufweist oder durch ein solches gebildet ist.

16. Optoelektronisches Bauelement nach einem der Ansprüche 1. bis 15,
**dadurch gekennzeichnet,**
**dass** das Element (1) durch einen VCSEL-Chip (VCSEL = Vertical Cavity Surface Emitting Laser) mit einer kohärent abstrahlenden Diode, einen IRED-Chip (IRED = InfraRed Emitting Diode), einen Chip mit einer spontan emittierenden Diode oder einen dergleichen an einer Oberfläche lichtemittierenden Chip gebildet ist.

17. Optoelektronisches Bauelement nach einem der Ansprüche 1 bis 16,
**dadurch gekennzeichnet,**
**dass** der Systemträger (9) mit dem daran befestigten Hilfsträger (2) mit einer lichtundurchlässigen Press-, Verguss- oder Moldmasse (10) wenigstens bereichsweise vergossen bzw. vermoldet ist.

18. Verfahren zur Herstellung eines optoelektronischen Bauelements, bestehend aus einem lichtemittierenden oder empfangenden Element (1) und einem Systemträger (9), für die Abstützung bzw. Montage des Bauelements, mit den Verfahrensschritten
- Vorsehen eines für das Licht wenigstens bereichsweise durchlässigen oder wenigstens durchscheinenden Hilfsträgers (2) aus einem wärmeleitenden Material, indem eine Aussparung (2a) für den ungehinderten Lichtdurchtritt in dem Hilfsträger (2) durch anisotropes Ätzen gefertigt wird,
- Verbinden des Hilfsträgers (2) mit dem Element (1), dabei Herstellen einer thermischen Kopplung zwischen dem Hilfsträger (2) und dem Element (1), und
- mechanisches Verbinden des das Element (1) tragenden Hilfsträgers (2) mit dem Systemträger (9), wobei beim Ätzen der Aussparung (2a) eine die Aussparung abdeckende Abdeckschicht mit einer Dicke von ≤ 50 µm stehen gelassen wird,
**dadurch gekennzeichnet,**
**dass** auf bzw. in dem Hilfsträger (2) und/oder dem Element (1) vor dem Verbinden derselben vermittels halbleitertechnologischer Strukturierungsschritte ein gegenüber dem Element (1) eigenständiger Sensor (3) ausgebildet wird und eine optische Einrichtung (11 oder 21) in einer Öffnung (9a) des Systemträgers (9) befestigt wird, wobei der Sensor (3) und die optische Einrichtung (11 oder 21) derart angeordnet werden, dass die fokussierende und/oder den Strahlengang des Lichts verändernde optische Einrichtung (11 oder 21) einen Teil eines vom Element (1) emittierten Lichtstrahls auf den Sensor (3) reflektiert.

19. Verfahren zur Herstellung eines optoelektronischen Bauelements nach Anspruch 18,
**dadurch gekennzeichnet,**
**dass** eine Vielzahl von Hilfsträgern (2), die in einem weiteren Verfahrensschritt zu vereinzeln sind, gemeinsam in einem Verbund mit eigenständigen Sensoren (3) und/oder den damit zu verbindenden Elementen (1) verbunden werden.

20. Verfahren zur Herstellung eines optoelektronischen Bauelements nach Anspruch 18 oder 19,
**dadurch gekennzeichnet,**
**dass** die optische Einrichtung (11 oder 21) in die Öffnung (9a) vermittels eines Haft- oder Klebemittels (12) eingeklebt wird.

21. Verfahren zur Herstellung eines optoelektronischen Bauelements nach einem der Ansprüche 18 bis 20,
**dadurch gekennzeichnet,**
**dass** der Systemträger (9) mit dem daran befestigten Hilfsträger (2) und dem daran befindlichen Element (1) mit einer lichtundurchlässigen Press-, Verguss- oder Moldmasse (10) wenigstens bereichsweise vergossen bzw. vermoldet wird.

## Claims

1. Optoelectronic component having a light-emitting element (1) and a system carrier (9) which supports the element (1), for supporting or mounting the component, an auxiliary carrier (2) made of a thermally conductive material being provided, at least regions of which are transparent or at least translucent for light, which is connected to the system carrier (9), on the one hand, and is thermally coupled to the element (1), on the other hand, and in which a recess (2a) is provided, through which the light passes, the recess (2a) in the auxiliary carrier (2) being covered with a thin covering layer formed from the latter, through which the light passes,
**characterised**
**in that** a light-sensitive sensor is provided, which is formed on/in the element (1) or on/in the substrate of the auxiliary carrier (2),
**in that** an optical arrangement (11 or 21) which focuses, and/or which modifies the beam path of the light, is provided in the optical axis (OA) of the component, and
**in that** the sensor is arranged in a region in which the optical arrangement (11 or 21) which focuses, and/or which modifies the beam path of the light, reflects some of a light beam emitted by the element (1).

2. Optoelectronic component according to Claim 1,
**characterised**
**in that** the auxiliary carrier (2) has an electrical bonding, by means of which it is electrically connected to the element (1).

3. Optoelectronic component according to Claim 1 or 2,
**characterised**
**in that** the auxiliary carrier (2) is arranged between the system carrier (9) and the element (1), and the auxiliary carrier (2) and the element (1) are mechanically connected in a substantially planar fashion.

4. Optoelectronic component according to one of Claims 1 to 3,
**characterised**
**in that** the system carrier (9), consisting of a non-transparent material, is provided with an opening (9a) through which light passes.

5. Optoelectronic component according to one of Claims 1 to 4,
**characterised**
**in that** the recess (2a) in the auxiliary carrier (2) and/or the opening (9a) of the system carrier (9) has the configuration of a truncated cone or truncated pyramid or of a cylinder, the walls of said recess (2a) and/or opening (9a) having smooth lateral faces (2c).

6. Optoelectronic component according to one of Claims 1 to 5,
**characterised**
**in that** the optical arrangement (11 or 21) is fitted inside the opening (9a) of the system carrier (9) and/or the recess (2a) of the auxiliary carrier (2).

7. Optoelectronic component according to one of Claims 1 to 6,
**characterised**
**in that** the optical arrangement is formed as a lens (11) or a transparent platelet (21), the platelet (21) being arranged at a defined angle (22) between its surface normal (FN) and the optical axis (OA) of the component.

8. Optoelectronic component according to Claim 7,
**characterised**
**in that** the angle (22) of the platelet arrangement is selected in such a way that a smallest possible proportion of light is reflected by the surface (23) of the platelet (21), and/or a predetermined proportion (14) thereof is reflected in a defined direction.

9. Optoelectronic component according to one of Claims 1 to 8,
**characterised**
**in that** a bonding or adhesive agent (12) is provided, by means of which the optical arrangement (11 or 21) is fixed inside the opening (9a) of the system carrier (9) and/or the recess (2a) of the auxiliary carrier (2).

10. Optoelectronic component according to one of Claims 1 to 9,
**characterised**
**in that**, in relation to the optical axis (OA) of the component, predetermined support points or support edges (2b) for the self-adjusting alignment of the optical arrangement (11 or 21) are provided on the lateral faces (2c) and/or edges of the recess (2a) of the auxiliary carrier (2) and/or the lateral faces (9b) and/or edges of the opening (9a) of the system carrier (9).

11. Optoelectronic component according to Claim 10,
**characterised**
**in that** the support points or support edges are arranged on the outermost edges (2b), facing away from the element (1), of the recess (2a) and/or on the outermost edges (9c), facing away from the element (1), of the opening (9a) and/or on a middle section of the opening wall or recess wall (lateral faces of the opening or recess) (9b or 2c).

12. Optoelectronic component according to one of Claims 1 to 11,
**characterised**
**in that** the sensor (3) is formed by an active electronic component, in particular semiconductor component, structured in/on the auxiliary carrier (2), or the covering layer formed therefrom, or the element (1).

13. Optoelectronic component according to one of Claims 1 to 12,
**characterised**
**in that** the sensor (3) is electrically coupled to the element (1), either indirectly via another circuit or directly.

14. Optoelectronic component according to Claim 2 or 3,
**characterised**
**in that** the semiconductor component is formed by a diode or a transistor.

15. Optoelectronic component according to one of Claims 1 to 14,
**characterised**
**in that** the auxiliary carrier (2) has a substrate made of silicon or of an SiC compound, or is formed by such a material.

16. Optoelectronic component according to one of Claims 1 to 15,
**characterised**
**in that** the element (1) is formed by a VCSEL chip (VCSEL = Vertical Cavity Surface Emitting Laser) having a coherently radiating diode, an IRED chip (IRED = InfraRed Emitting Diode), a chip having a spontaneously emitting diode or such a chip emitting light on a surface.

17. Optoelectronic component according to one of Claims 1 to 16,
**characterised**
**in that** the system carrier (9), with the auxiliary carrier (2) attached thereto, is potted or moulded at least in some areas with a non-transparent pressing, casting or moulding mass (10).

18. Method for producing an optoelectronic component,
consisting of a light-emitting or light receiving element (1) and a system carrier (9), for supporting or mounting the component, having the process steps
- provision of an auxiliary carrier (2) made of a thermally conductive material, at least regions of which are transparent or at least translucent for the light, by fabricating a recess (2a) for unimpeded passage of light in the auxiliary carrier (2) by anisotropic etching,
- connection of the auxiliary carrier (2) to the element (1), while producing thermal coupling between the auxiliary carrier (2) and the element (1), and
- mechanical connection of the auxiliary carrier (2), carrying the element (1), to the system carrier (9), a covering layer with a thickness of ≤ 50 µm, which covers the recess, being left in place during the etching of the recess (2a),
**characterised**
**in that** a sensor (3), which is independent of the element (1), is formed by means of semiconductor-technological structuring steps on/in the auxiliary carrier (2) and/or the element (1), before the connection thereof, and an optical arrangement (11 or 21) is fixed in an opening (9a) of the system carrier (9), the sensor (3) and the optical arrangement (11 or 21) being arranged in such a way that the optical arrangement (11 or 21) which focuses, and/or which modifies the beam path of the light, reflects onto the sensor (3) some of a light beam emitted by the element (1).

19. Method for producing an optoelectronic component according to Claim 18,
**characterised**
**in that** a plurality of auxiliary carriers (2), which are to be separated in a further process step, are connected jointly in a composite structure with independent sensors (3) and/or with the elements (1) to be connected thereto.

20. Method for producing an optoelectronic component according to Claim 18 or 19,
**characterised**
**in that** the optical arrangement (11 or 21) is bonded into the opening (9a) by means of a bonding or adhesive agent (12).

21. Method for producing an optoelectronic component according to one of Claims 18 to 20,
**characterised**
**in that** the system carrier (9), with the auxiliary carrier (9) attached thereto and the element (1) located thereon, is potted or moulded at least in some areas with a non-transparent pressing, casting or moulding mass (10).

## Revendications

1. Composant optoélectronique avec un élément émetteur de lumière (1) et un support de système (9) supportant l'élément (1), pour l'appui ou le montage du composant, un support secondaire (2) transparent, ou au moins translucide, au moins par zones en un matériau thermoconducteur étant prévu, qui d'une part est relié au support de système (9) et qui d'autre part est en couplage thermique avec l'élément (1) et dans lequel est prévue une échancrure (2a), à travers laquelle passe la lumière, l'échancrure (2a) dans le support secondaire (2) étant recouverte d'une mince couche protectrice, à travers laquelle passe la lumière,
**caractérisé en ce que**
on a prévu un capteur photosensible, qui est conçu sur, voire dans l'élément (1) ou sur, voire dans le substrat du support secondaire (2),
**en ce que** dans l'axe optique (OA) du composant, on a prévu un dispositif optique (11 ou 21) de focalisation et/ou modifiant la trajectoire du faisceau lumineux, et
**en ce que** le capteur est disposé dans une zone dans laquelle le dispositif optique (11 ou 21) de focalisation et/ou modifiant la trajectoire du faisceau lumineux réfléchit une partie du faisceau lumineux émis par l'élément (1).

2. Composant optoélectronique selon la revendication 1,
**caractérisé en ce que**
le support secondaire (2) comporte un contact électrique, au moyen duquel il est électriquement relié avec l'élément (1).

3. Composant optoélectronique selon la revendication 1 ou 2,
**caractérisé en ce que**
le support secondaire (2) est disposé entre le support de système (9) et l'élément (1) et **en ce que** le support secondaire (2) et l'élément (1) sont reliés mécaniquement l'un avec l'autre sensiblement sur une surface.

4. Composant optoélectronique selon l'une quelconque des revendications 1 à 3,
**caractérisé en ce que**
le support de système (9) en un matériau non transparent est muni d'un orifice (9a) à travers lequel passe la lumière.

5. Composant optoélectronique selon l'une quelconque des revendications 1 à 4,
**caractérisé en ce que**
l'échancrure (2a) dans le support secondaire (2) et/ou l'orifice (9a) du support de système (9) est conçu(e) sous forme tronconique, de pyramide tronquée ou cylindrique, avec des surfaces latérales lisses (2c) sur sa paroi.

6. Composant optoélectronique selon l'une quelconque des revendications 1 à 5,
**caractérisé en ce que**
le dispositif optique (11 ou 21) est ajusté dans l'orifice (9a) du support de système (9) et/ou dans l'échancrure (2a) du support secondaire (2).

7. Composant optoélectronique selon la revendication 1 à 6,
**caractérisé en ce que**
le dispositif optique est conçu sous la forme d'une lentille (11) ou d'une plaquette transparente (21), la plaquette (21) étant disposée sous un angle défini (22) entre sa normale de surface (FN) et l'axe optique (OA) du composant.

8. Composant optoélectronique selon la revendication 7,
**caractérisé en ce que**
l'angle (22) de disposition de la plaquette est choisi de façon telle, qu'une partie la plus faible possible soit réfléchie par la surface (23) de la plaquette (21) et/ou qu'une partie prédéfinie (14) soit reflétée dans une direction définie.

9. Composant optoélectronique selon l'une quelconque des revendications 1 à 8,
**caractérisé en ce que**
on a prévu un agent adhérent ou adhésif (12) au moyen duquel le dispositif optique (11 ou 21) est fixé dans l'orifice (9a) du support de système (9) et/ou dans l'échancrure (2a) du support secondaire (2).

10. Composant optoélectronique selon l'une quelconque des revendications 1 à 9,
**caractérisé en ce que**
on a prévu par rapport à l'axe optique (OA) du composant, sur les surfaces latérales (2c) et/ou sur les arêtes de l'échancrure (2a) du support secondaire (2) et/ou sur les surfaces latérales (9b) et/ou sur les arêtes de l'orifice (9a) du support de système (9) des points d'appui ou arêtes d'appui prédéfini(e)s (2b) pour l'alignement auto-ajustable du dispositif optique (11 ou 21).

11. Composant optoélectronique selon la revendication 10,
**caractérisé en ce que**
les points d'appui ou arêtes d'appui sont disposé(e)s sur les bords (2b) les plus à l'extérieur de l'échancrure (2a) qui sont opposés à l'élément (1) ou sur les bords (9c) les plus à l'extérieur de l'orifice (9a) qui sont opposés à l'élément (1) et/ou sur une section médiane de la paroi (des surfaces latérales)de l'orifice ou de l'échancrure (9b ou 2c).

12. Composant optoélectronique selon l'une quelconque des revendications 1 à 11,
**caractérisé en ce que**
le capteur (3) consiste en un composant électronique actif structuré, notamment en un élément semi-conducteur, conçu dans, voire sur le support secondaire (2), voire sur la couche protectrice conçue en ce dernier ou sur l'élément (1).

13. Composant optoélectronique selon l'une quelconque des revendications 1 à 12,
**caractérisé en ce que**
le capteur (3) est électriquement couplé avec l'élément (1)indirectement par l'intermédiaire d'un autre circuit ou directement.

14. Composant optoélectronique selon la revendication 2 ou 3,
**caractérisé en ce que**
le composant semi-conducteur consiste en une diode ou en un transistor.

15. Composant optoélectronique selon l'une quelconque des revendications 1 à 14,
**caractérisé en ce que**
le support secondaire (2) comporte un substrat en silicium ou en un composé SiC ou consiste en un tel substrat.

16. Composant optoélectronique selon l'une quelconque des revendications 1 à 15,
**caractérisé en ce que**
l'élément (1) consiste en une puce VCSEL (VCSEL = Laser à cavité verticale avec émission de surface) avec une diode à rayonnement cohérent, en une puce IRED (IRED = Diode électroluminescente infrarouge), en une puce avec une diode à émission spontanée ou en une puce similaire, électroluminescente sur une surface.

17. Composant optoélectronique selon l'une quelconque des revendications 1 à 16,
**caractérisé en ce que**
le support de système (9) avec le support secondaire (2) fixé dessus est encapsulé ou moulé au moins par zones avec une matière d'injection, d'enrobage ou de moulage (10) opaque.

18. Procédé de fabrication d'un composant optoélectronique avec un élément émetteur ou récepteur de lumière (1) et un support de système (9), pour l'appui ou le montage du composant, avec les étapes de procédé consistant à
- prévoir un support secondaire (2) transparent, ou au moins translucide, au moins par zones en un matériau thermoconducteur dans lequel on élabore par gravure anisotrope une échancrure (2a) pour le libre passage de la lumière dans le support secondaire (2),
- assembler le support secondaire (2) avec l'élément (1) en créant à cet effet un couplage thermique entre le support secondaire (2) et l'élément (1), et
- assembler mécaniquement le support secondaire (2) portant l'élément (1) avec le support de système (9) en laissant lors de la gravure de l'échancrure (2a) une couche protectrice recouvrant l'échancrure, d'une épaisseur ≤ 50 µm,
**caractérisé en ce que**
avant leur assemblage, on conçoit sur, voire dans le support secondaire (2) et/ou l'élément (1), au moyen d'étapes de structuration relevant de la technologie des semiconducteurs, un capteur (3) indépendant par rapport à l'élément (1) et on fixe un dispositif optique (11 ou 21) dans un orifice (9a) du support de système (9), tout en disposant le capteur (3) et le dispositif optique (11 ou 21) de façon à ce que le dispositif optique (11 ou 21) de focalisation et/ou modifiant le trajet du faisceau lumineux réfléchisse sur le capteur (3) une partie du faisceau lumineux émis par l'élément (1).

19. Procédé de fabrication d'un composant optoélectronique selon la revendication 18,
**caractérisé en ce que**
on assemble en commun en un corps composite une pluralité de supports secondaires (2) qui devront être désolidarisés au cours d'une étape ultérieure du procédé avec des capteurs indépendants (3) et/ou avec les éléments (1) devant être assemblés avec ces derniers.

20. Procédé de fabrication d'un composant optoélectronique selon la revendication 18 ou 19,
**caractérisé en ce que**
on colle le dispositif optique (11 ou 21) dans l'orifice (9a) au moyen d'un agent adhésif ou une colle (12).

21. Procédé de fabrication d'un composant optoélectronique selon l'une quelconque des revendications 18 à 20,
**caractérisé en ce que**
le support de système (9) avec le support secondaire (2) fixé dessus et l'élément (1) se trouvant sur ce dernier est encapsulé ou moulé au moins par zones avec une matière d'injection, d'enrobage ou de moulage (10) opaque.
